# EUROPÄISCHE PATENTSCHRIFT

(11) **EP 3 381 127 B1**
(45) Veröffentlichungstag und Bekanntmachung des Hinweises auf die Patenterteilung: **20.10.2021**
(21) Anmeldenummer: 16801174.0
(22) Anmeldetag: 22.11.2016
(51) Int. Cl.: H03K 17/14, H03K 17/16

(54) **SCHALTUNGSANORDNUNG ZUR TEMPERATURABHÄNGIGEN ANSTEUERUNG EINES SCHALTELEMENTES**
CIRCUIT ARRANGEMENT FOR THE TEMPERATURE-DEPENDENT ACTUATION OF A SWITCHING ELEMENT
AGENCEMENT DE CIRCUIT DESTINÉ À LA COMMANDE DÉPENDANTE DE LA TEMPÉRATURE D'UN ÉLÉMENT DE COMMUTATION

(30) Priorität: 26.11.2015 DE 102015223465
(43) Veröffentlichungstag der Anmeldung: 03.10.2018
(73) Patentinhaber: Robert Bosch GmbH, 70442 Stuttgart (DE)
(72) Erfinder: SINN, Peter, 74199 Untergruppenbach (DE); BARTSCH, Timo, 71296 Heimsheim (DE)
(86) Internationale Anmeldenummer: PCT/EP2016/078365
(87) Internationale Veröffentlichungsnummer: WO 2017/089321

(56) Entgegenhaltungen:
- EP-A1- 2 871 776
- DE-A1-102009 015 322
- DE-A1-102010 043 109
- US-A- 5 986 484

## Beschreibung

Die Erfindung betrifft eine Schaltungsanordnung zur temperaturabhängigen Ansteuerung eines ersten Schaltelementes. Ferner betrifft die Erfindung ein Schaltungsmodul, einen Wechselrichter sowie die Verwendung der Schaltungsanordnung.

### Stand der Technik

Schaltelemente, insbesondere Leistungshalbleiterschalter wie Bipolartransistoren, IGBTs, MOSFETs werden mit einer Treiberschaltung angesteuert. Hierbei wird zum Schließen des Schaltelementes ein vorgebbares, festes Spannungspotential an den Steueranschluss des Halbleiters, an das Gate, angelegt. Die Schaltgeschwindigkeit des Schaltelementes kann durch einen Vorwiderstand eingestellt werden, der zwischen der Ansteuerschaltung und dem Steueranschluss des Halbleiters angeordnet ist. Je höher der Vorwiderstand, desto langsamer und verlustbehafteter der Schaltvorgang. Mittels dieses Vorwiderstands kann jedoch ein temperaturabhängiges Schaltverhalten eines Halbleiters nicht berücksichtigt werden. Es ist bekannt, dass sich mit ansteigender Temperatur des Halbleiters die Schaltverluste im Allgemeinen erhöhen. Zur Minimierung der Schaltverluste müsste mit steigender Temperatur die Schaltgeschwindigkeit des Schaltelementes reduziert werden. Hierzu wäre ein niedrigerer Vorwiderstand einzusetzen. Wenn die Temperatur wieder abnimmt, beispielsweise bei Raumtemperatur, entstünden dann jedoch aufgrund des geringen Vorwiderstandes sehr schnelle Schaltflanken. Diese führen zu elektromagnetischen Störungen und zu Überspannungen, die den Halbleiter schädigen können.

Aus der DE 199 13 465 ist eine Schaltungsanordnung zur Ansteuerung eines Leistungstransistors bekannt, der mittels einer Gegentaktstufe angesteuert wird. Für das Ein- und Ausschalten des Leistungstransistors sind unterschiedliche Vorwiderstände vorgesehen, um ein gewünschtes Ein- und Ausschalten des Halbleiters einzustellen. Das Dokument DE 10 2010 043 109 A1 offenbart eine Schaltungsanordnung mit temperaturabhängiger variabler Pulsweitenmodulation zur Ansteuerung eines Schaltelementes. Das Dokument EP 2 871 776 A1 offenbart eine Leistungshalbleiterschaltung zur Reduktion der Schaltverluste bei Erwärmung eines Leistungshalbleiterschaltersmit einem temperaturabhängigen Steueranschlusswiderstandselement. Das Dokument US 5 986 484 offenbart eine Ansteuerschaltung für einen Halbleiterschalter, welche die Unterdrückung eines Spannungsstoßes während des Abschaltbetriebs und eine Reduktion der Schaltverluste ermöglicht. Das Dokument DE 10 2009 015 322 A1 offenbart eine temperaturabhängige Ansteuerschaltung für einen Halbleiterschalter.

Es besteht das Bedürfnis, derartige Ansteuerungen zu verbessern, sodass auch bei unterschiedlichen Temperaturen ein gewünschtes Schaltverhalten ermöglicht wird.

### Offenbarung der Erfindung

Es wird eine Schaltungsanordnung zur temperaturabhängigen Ansteuerung eines ersten Schaltelementes bereitgestellt. Diese Schaltungsanordnung umfasst einen Eingangsanschluss zur Entgegennahme eines Eingangspotentials, einen Ausgangsanschluss zur Weitergabe eines Ausgangspotentials an einen ersten Steueranschluss des ersten Schaltelementes und ein temperaturabhängiges Bauelement. Das temperaturabhängige Bauelement ist zwischen den Einganganschluss und den Ausgangsanschluss geschaltet.

Es wird somit eine Schaltungsanordnung bereitgestellt, bei der eingangsseitig ein Eingangspotential beziehungsweise eine Eingangssteuerspannung angelegt wird. Ausgangsseitig liegt in Abhängigkeit der Eingangssteuerspannung ein Ausgangspotential beziehungsweise eine Ausgangssteuerspannung am ersten Steueranschluss des ersten Schaltelementes an. Zwischen der Treiberschaltung und dem Steueranschluss des ersten Schaltelementes, insbesondere eines Halbleiterschalters, ist weiter ein temperaturabhängiges Bauelement angeordnet. Ein temperaturabhängiges Bauelement kann auf vielfältige Weise ausgeführt sein, beispielsweise als eine Schaltung aus Operationsverstärkern, die temperaturabhängig angesteuert werden. Auch eine prozessorgesteuerte Schaltung, bei der ein Temperatursensor ausgelesen wird oder ein temperaturabhängiger Widerstand wird in diesem Zusammenhang als temperaturabhängiges Bauelement betrachtet. Ein temperaturabhängiger Widerstand beispielsweise kann einen positiven oder einen negativen Temperaturkoeffizienten aufweisen. Bei einem temperaturabhängigen Widerstand mit einem negativen Temperaturkoeffizienten (NTC) nimmt der Wert des Widerstandes mit steigender Temperatur ab, bei einem temperaturabhängigen Widerstand mit positiven Temperaturkoeffizienten (PTC) nimmt der Wert des Widerstandes mit steigender Temperatur zu. Es bietet sich daher an, einen temperaturabhängigen Widerstand mit einem negativen Temperaturkoeffizienten (NTC) zwischen einer Treiberschaltung und dem Steueranschluss des Halbleiters anzuordnen. Eine Erhöhung der Schaltverluste und ein Verlangsamen des Schaltverhaltens des Schaltelementes kann somit trotz steigender Temperaturen vermieden werden. Auch bei einer Serienschaltung oder Parallelschaltung, die zwischen einer Treiberschaltung und dem Steueranschluss des Halbleiters angeordnet und aus Vorwiderstand und temperaturabhängigen Widerstand bestehen könnte, nimmt mit steigender Temperatur der daraus resultierende Gesamtvorwiderstand ab. In einer Serienschaltung aus einem temperaturabhängigen Widerstand und einem Vorwiderstand, gibt der Widerstandswert des Vorwiderstands den geringsten Wert des resultierenden Gesamtvorwiderstands der Anordnung vor. Besonders bei großen Ansteuerströmen und hohen Taktfrequenzen besteht die Gefahr, dass die Eigenerwärmung des temperaturabhängigen Widerstandes schneller als die Erwärmung des Halbleiters selbst erfolgt. Es können daher Betriebspunkte auftreten, bei denen der temperaturabhängige Widerstand bereits heiß ist und folglich nur noch einen sehr geringen Widerstandswert aufweist, obwohl das Schaltelement selbst noch nicht gewärmt ist. Der resultierende Betrieb des Schaltelementes mit einem vergleichsweise zu geringen Vorwiderstand kann zu schädlichen Überspannungen und elektromagnetischen Störungen führen.

Erfindungsgemäß umfasst die Schaltungsanordnung weiter ein zweites Schaltelement und einen ersten Widerstand. Der erste Widerstand ist mit dem temperaturabhängigen Bauelement in Reihe geschaltet. Diese Reihenschaltung ist zwischen den Eingangsanschluss und den Ausgangsanschluss geschaltet. Das zweite Schaltelement ist ebenfalls zwischen den Eingangsanschluss und den Ausgangsanschluss, insbesondere parallel zur Reihenschaltung, geschaltet. Das zweite Schaltelement weist einen zweiten Steueranschluss auf, welcher mit dem Mittelabgriff zwischen dem ersten Widerstand und dem temperaturabhängigen Bauelement verbunden ist.

Durch das Vorsehen eines zweiten Schaltelementes, welches zwischen dem Eingangs- und dem Ausgangsanschluss angeordnet ist und dessen Steueranschluss mit dem Mittelabgriff zwischen einem ersten Widerstand und dem temperaturabhängigen Bauelement verbunden ist, wird ein Zu- und Abschalten eines weiteren Strompfades zwischen dem Eingangs- und dem Ausgangsanschluss ermöglicht. Der erste Widerstand, der in Reihe mit dem temperaturabhängigen Widerstand zwischen den Eingangsanschluss und den Ausgangsanschluss geschaltet ist, wirkt zusammen mit dem temperaturabhängigen Widerstand als Spannungsteiler. Durch die Dimensionierung dieses Spannungsteilers wird die Steuerung des zweiten Schaltelementes eingestellt. Über die Größe des ersten Widerstandes in Zusammenhang mit dem temperaturabhängigen Widerstand ist einstellbar, bei welcher Temperatur das zweite Schaltelement angesteuert wird und der weitere Strompfad zwischen dem Eingangsanschluss und den Ausgangsanschluss zur Ansteuerung des ersten Schaltelementes leitend geschaltet wird. Wenn der weitere Strompfad leitet, wirkt ein geringerer Gesamtvorwiderstand im Ansteuerpfad des ersten Schaltelementes. Vorteilhaft wird mittels Vorsehen des ersten Widerstandes eine Möglichkeit geschaffen, die Temperatur, bei der das zweite Schaltelement umschaltet, einzustellen oder vorzugeben. Vorteilhaft wird somit ein weiterer Strompfad zwischen dem Eingangs- und Ausgangsanschluss bereitgestellt, der in Abhängigkeit der Steuerspannung am zweiten Steueranschluss des zweiten Schaltelementes zu- und abgeschaltet wird und somit eine signifikante Veränderung, also Absenkung oder Erhöhung, des wirkenden Gesamtvorwiderstands des ersten Steueranschlusses ermöglicht, insbesondere temperaturabhängig.

In einer anderen Ausgestaltung der Erfindung ist vorgesehen, dass die Schaltungsanordnung weiter einen zweiten Widerstand umfasst, wobei der zweite Widerstand zwischen den Eingangsanschluss und den Ausgangsanschluss geschaltet ist, insbesondere parallel geschaltet ist zu dem Strompfad durch das zweite Schaltelement und zu der Reihenschaltung.

Die Schaltungsanordnung umfasst einen zweiten Widerstand, der im Wesentlichen temperaturunabhängig als Vorwiderstand des Steueranschlusses des ersten Schaltelementes wirkt. Vorteilhaft kann mittels geeigneter Dimensionierung dieses Vorwiderstandes das Schaltverhalten des ersten Schaltelementes grundlegend eingestellt werden. Der zweite Widerstand wird so dimensioniert, dass schädliche Überspannungen sowie störende elektromagnetische Emissionen beim Betrieb des ersten Schaltelementes vermieden werden.

In einer anderen Ausgestaltung der Erfindung ist vorgesehen, dass die Schaltungsanordnung weiter einen dritten Widerstand umfasst. Der dritte Widerstand ist zwischen den Eingangsanschluss und das zweite Schaltelement geschaltet.

Der dritte Widerstand, der zwischen den Eingangsanschluss und das zweite Schaltelement geschaltet ist, bestimmt den wirkenden Widerstand des weiteren Strompfades zwischen dem Eingangs- und dem Ausgangsanschluss, wenn das zweite Schaltelement geschlossen ist. Insbesondere bei höheren Temperaturen, wenn der temperaturabhängige Widerstand einen geringen Wert aufweist, schließt das zweite Schaltelement und ein Stromfluss durch den weiteren Strompfad, also durch den dritten Widerstand und das zweite Schaltelement zum Ausgangsanschluss, wird möglich. Der wirkende Gesamtvorwiderstand zwischen Eingangs- und Ausgangsanschluss erniedrigt sich dabei. Der wirkende Gesamtvorwiderstand ergibt sich dabei im Wesentlichen aus der Parallelschaltung des zweiten und des dritten Widerstandes, wenn der temperaturabhängige Widerstand hochohmig ist. Vorteilhaft wird eine Möglichkeit geschaffen, den wirkenden Widerstand zwischen Eingangs- und Ausgangsanschluss temperaturunabhängig auf einen vorgebbaren niedrigeren Wert zu reduzieren.

In einer anderen Ausgestaltung der Erfindung umfasst die Schaltungsanordnung eine erste Diode. Diese erste Diode ist zwischen den dritten Widerstand und das zweite Schaltelement geschaltet. Die Diode ist derart ausgerichtet, dass ein Stromfluss aus dem zweiten Schaltelement in Richtung des dritten Widerstandes verhindert wird.

Zwischen das zweite Schaltelement und den dritten Widerstand ist eine erste Diode, die einen Stromfluss aus dem zweiten Schaltelement in Richtung des dritten Widerstandes verhindert, geschaltet. Vorteilhaft wird so ein unerwünschter Stromfluss durch die Body-Diode des zweiten Schaltelementes, insbesondere eines n-Kanal-MOSFETs, vermieden. Diese Ausgestaltung der Schaltungsanordnung ist insbesondere für das Einschalten des ersten Schaltelementes geeignet.

In einer anderen Ausgestaltung der Erfindung ist diese erste Diode derart ausgerichtet, dass ein Stromfluss aus dem dritten Widerstand in Richtung des zweiten Schaltelementes verhindert wird.

Zwischen das zweite Schaltelement und den dritten Widerstand ist eine erste Diode, die einen Stromfluss aus dem dritten Widerstand in Richtung des zweiten Schaltelementes verhindert, geschaltet. Vorteilhaft wird so ein unerwünschter Stromfluss durch die Body-Diode des zweiten Schaltelementes, insbesondere eines p-Kanal-MOSFETs, vermieden. Diese Ausgestaltung der Schaltungsanordnung ist insbesondere für das Ausschalten des ersten Schaltelementes geeignet.

Ferner wird ein Schaltungsmodul bereitgestellt, welches eine beschriebene Schaltungsanordnung zur temperaturabhängigen Ansteuerung eines ersten Schaltelementes umfasst und das an den Ausgangsanschluss angeschlossene erste Schaltelement. Vorteilhaft wird somit ein Schaltungsmodul mit einem Schaltelement und einer temperaturabhängigen Ansteuerung bereitgestellt.

In einer anderen Ausgestaltung der Erfindung umfasst das Schaltungsmodul weiter eine an den Eingangsanschluss angeschlossene Treiberschaltung. Vorteilhaft wird ein Schaltungsmodul bereitgestellt, mit einer temperaturabhängigen Ansteuerung, einem ersten Schaltelement und einer Treiberschaltung.

Ferner wird ein Wechselrichter bereitgestellt, welcher ein beschriebenes Schaltungsmodul umfasst. Ein Wechselrichter dient der Wandlung einer Gleichspannung, beispielsweise aus einer Batterie, in eine Wechselspannung, z. B. zur Versorgung eines elektrischen Antriebes. Vorteilhaft wird ein Wechselrichter bereitgestellt, der eine temperaturabhängige Ansteuerung eines ersten Schaltelementes umfasst.

Ferner wird ein elektrischer Antriebsstrang bereitgestellt, der einen beschriebenen Wechselrichter und eine elektrische Maschine umfasst. Vorteilhaft wird ein elektrischer Antriebsstrang mit einer temperaturabhängigen Ansteuerung eines ersten Schaltelementes zur Versorgung der angeschlossenen elektrischen Maschine mit Wechselspannung bereitgestellt.

Ferner betrifft die Erfindung die Verwendung einer Schaltungsanordnung zur temperaturabhängigen Ansteuerung eines ersten Schaltelementes in einem Kraftfahrzeug. Insbesondere betrifft die Erfindung auch die Verwendung eines beschriebenen Schaltungsmoduls, eines beschriebenen Wechselrichters oder eines elektrischen Antriebsstrangs.

Es versteht sich, dass die Merkmale, Eigenschaften und Vorteile der erfindungsgemäßen Schaltungsanordnung entsprechend auf das Schaltungsmodul bzw. den Wechselrichter, den elektrischen Antriebsstrang und für deren Verwendung und umgekehrt zutreffen, bzw. anwendbar sind.

Weitere Merkmale und Vorteile von Ausführungsformen der Erfindungen ergeben sich aus der nachfolgenden Beschreibung mit Bezug auf die beigefügten Zeichnungen.

### Kurze Beschreibung der Zeichnung

Im Folgenden soll die Erfindung anhand einiger Figuren näher erläutert werden, dazu zeigen:
- Figur 1: eine Schaltungsanordnung zur temperaturabhängigen Ansteuerung eines Schaltelementes nach dem Stand der Technik,
- Figur 2: eine Schaltungsordnung zur temperaturabhängigen Ansteuerung gemäß der Erfindung,
- Figur 3: eine erste Alternative der Schaltungsanordnung zur temperaturabhängigen Ansteuerung,
- Figur 4: eine zweite Alternative der Schaltungsanordnung zur temperaturabhängigen Ansteuerung,
- Figur 5: eine dritte Alternative der Schaltungsanordnung zur temperaturabhängigen Ansteuerung,
- Figur 6: eine vierte Alternative der Schaltungsanordnung zur temperaturabhängigen Ansteuerung,
- Figur 7: ein Schaltungsmodul umfassend eine temperaturabhängige Ansteuerung,
- Figur 8: eine schematische Darstellung eines elektrischen Antriebsstrangs.

### Ausführungsformen der Erfindung

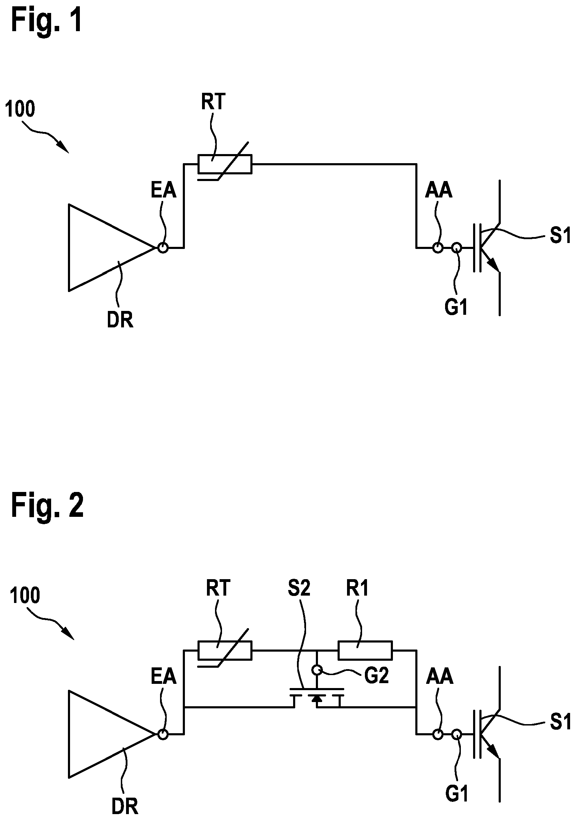

Die Figur 1 zeigt eine Schaltungsanordnung 100 nach dem Stand der Technik, umfassend einen Eingangsanschluss EA, einen Ausgangsanschluss AA und ein temperaturabhängiges Bauelement RT. Beispielhaft ist ein temperaturabhängiger Widerstand als temperaturabhängiges Bauelement RT dargestellt, welches zwischen dem Eingangsanschluss EA und dem Ausgangsanschluss AA angeordnet ist. Die Schaltungsanordnung dient der temperaturabhängigen Ansteuerung eines ersten Schaltelementes S1, dessen Steueranschluss G1 mit dem Ausgangsanschluss AA verbindbar ist. Der Eingangsanschluss EA der Schaltungsanordnung 100 ist mit dem Ausgang einer Treiberschaltung DR zur Entgegennahme eines von der Treiberschaltung DR erzeugten Eingangspotentials verbindbar. Zur Reduktion des wirkenden Gesamtvorwiderstandes der Schaltungsanordnung 100 bei steigenden Temperaturen bietet es sich an, als temperaturabhängigen Widerstand RT einen Widerstand mit einem negativen Temperaturkoeffizienten (NTC) zu verwenden. Bei dieser Ausgestaltung reduziert sich der wirkende Gesamtvorwiderstand der Schaltungsanordnung 100 kontinuierlich gemäß der Kennlinie des temperaturabhängigen Widerstandes RT.

Gemäß Figur 2 umfasst die Schaltungsanordnung 100 erfindungsgemäß ein zweites Schaltelement S2. Das zweite Schaltelement S2 ist ebenfalls zwischen den Eingangsanschluss EA und den Ausgangsanschluss AA geschaltet. Weiter umfasst die Schaltungsanordnung 100 einen ersten Widerstand R1, der in Reihe mit dem temperaturabhängigen Widerstand RT zwischen den Eingangsanschluss EA und den Ausgangsanschluss AA geschaltet ist. Ein Mittelabgriff zwischen dem ersten Widerstand R1 und dem temperaturabhängigen Widerstand RT ist mit dem zweiten Steueranschluss G2 des zweiten Schaltelementes S2 verbunden. Der erste Widerstand R1 und der temperaturabhängige Widerstand RT bilden zusammen einen Spannungsteiler. In Abhängigkeit der Größe des ersten Widerstandes R1 lässt sich die Temperatur einstellen, bei der das zweite Schaltelement S2 aufgrund der am zweiten Steueranschluss G2 des zweiten Schaltelementes S2 anliegenden Steuerspannung schaltet. Gemäß dieser Ausgestaltung wird das zweite Schaltelement S2 leitfähig, wenn der Widerstandswert des temperaturabhängigen Widerstandes RT aufgrund ansteigender Temperaturen einen bestimmten Wert unterschritten hat und somit die Steuerspannung am zweiten Steueranschluss G2 groß genug zum Schließen des zweiten Schaltelementes S2 ist. Das zweite Schaltelement S2 kann beispielsweise als MOSFET, insbesondere als n-Kanal MOSFET, ausgeführt sein. Dieses Schaltelement kann sowohl in seinem analogen Betrieb, auch Verstärkerbetrieb genannt, mit geringeren analogen Steuerspannungsänderungen des Steueranschluss G2 betrieben werden oder im schaltenden Betrieb mit entsprechend großen Steuerspannungsänderungen am Steueranschluss G2.

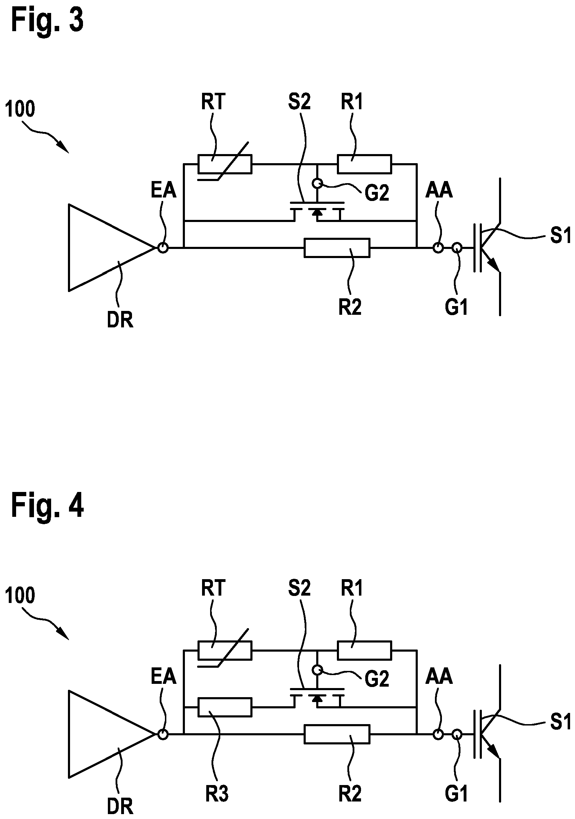

Gemäß Figur 3 umfasst die Schaltungsanordnung 100 einen zweiten Widerstand R2, der ebenfalls zwischen dem Eingangsanschluss EA und dem Ausgangsanschluss AA geschaltet ist. Gemäß dieser Ausgestaltung wird mittels des zweiten Widerstandes R2 ein temperaturunabhängig wirkender zweiter Widerstand R2 vorgegeben, über dessen Größe das Schaltverhalten des ersten Schaltelementes S1 einstellbar ist. Mit steigender Temperatur nimmt der Widerstand des temperaturabhängigen Widerstandes RT weiter ab. Die Steuerspannung an dem Steueranschluss G2 des zweiten Schaltelementes S2 steigt entsprechend an. Wenn die Steuerspannung einen Schwellwert überschritten hat, schließt das zweite Schaltelement S2 und ermöglicht einen Stromfluss parallel zum zweiten Widerstand R2 durch das zweite Schaltelement S2. Dabei reduziert sich der wirkende Gesamtvorwiderstand der Schaltungsanordnung 100. Umgekehrt sinkt die Steuerspannung an dem Steueranschluss G2 des zweiten Schaltelementes S2 mit fallender Temperatur. Wenn die Steuerspannung einen Schwellwert unterschritten hat, öffnet das zweite Schaltelement S2 und unterbindet einen Stromfluss parallel zum zweiten Widerstand R2. Dabei erhöht sich der wirkende Gesamtvorwiderstand der Schaltungsanordnung 100.

Die Schaltungsanordnung gemäß Figur 4 umfasst weiter einen dritten Widerstand R3, welcher zwischen den Eingangsanschluss EA und das zweite Schaltelement S2 geschaltet ist. Mittels Dimensionierung des dritten Widerstand R3 wird das Schaltverhalten des ersten Schaltelementes S1 eingestellt für den Fall, dass ein Stromfluss durch das zweite Schaltelement S2 aufgrund erhöhter Temperaturen am temperaturabhängigen Widerstand RT möglich ist.

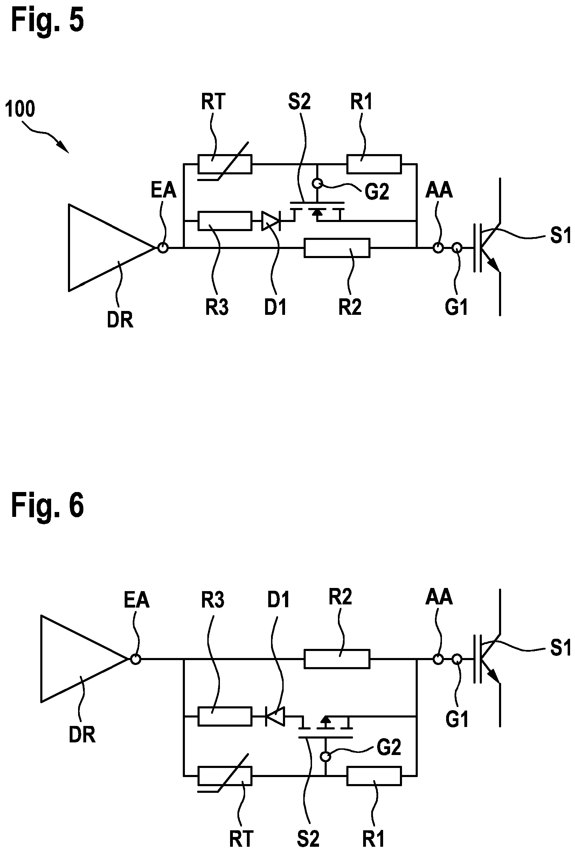

Die Schaltungsanordnung gemäß Figur 5 umfasst weiter eine erste Diode D1, die zwischen dem zweiten Schaltelement S2 und dem dritten Widerstand R3 angeordnet ist. Die Diode D1 ist so ausgerichtet, dass ein Stromfluss von dem zweiten Schaltelement S2 in Richtung des dritten Widerstandes R3 nicht möglich ist.

Die dargestellten Ausführungen zum Einschaltvorgang des ersten Schaltelementes S1 gelten analog auch für den Ausschaltvorgang des ersten Schaltelementes S1. Somit ist speziell für den Ausschaltvorgang eine Schaltungsanordnung 100 nach Fig. 6 vorgesehen, die im Wesentlichen komplementär zu den bisher beschriebenen Schaltungsanordnungen 100 aufgebaut ist. Die Schaltungsanordnung 100 weist ebenfalls ein temperaturabhängiges Bauelement RT, insbesondere einen temperaturabhängigen Widerstand, auf. Dieser ist insbesondere in Reihe mit einem ersten Widerstand R1 zwischen den Eingangs- und den Ausgangssanschluss EA, AA geschaltet. Parallel zu dieser Reihenschaltung ist ein zweites Schaltelement S2 geschaltet, dessen zweiter Steueranschluss G2 mit dem Mittelabgriff des Spannungsteilers aus dem temperaturabhängigen Widerstand RT und dem ersten Widerstand R1 verbunden ist. Zwischen den Eingangsanschluss EA und das zweite Schaltelement S2, welches insbesondere ein p-kanal MOSFET ist, ist insbesondere ein dritter Widerstand R3 und/ oder eine erste Diode D1 geschaltet. Die erste Diode D1 ist in diesem Fall so ausgerichtet, dass ein Stromfluss von dem dritten Widerstand R3 in Richtung des zweiten Schaltelement S2 nicht möglich ist. Optional kann wiederum ein zweiter Widerstand R2 parallel zu den beschriebenen Bauelementen zwischen den Eingangsanschluss EA und den Ausgangsanschluss AA geschaltet werden.

Es versteht sich, dass die dargestellten Ausführungen zum Einschaltvorgang und zum Ausschaltvorgang kombiniert werden können, also insbesondere die komplementären Schaltungen nach Fig. 5 und Fig. 6 gemeinsam zur Ansteuerung des ersten Schaltelementes S1 eingesetzt werden können.

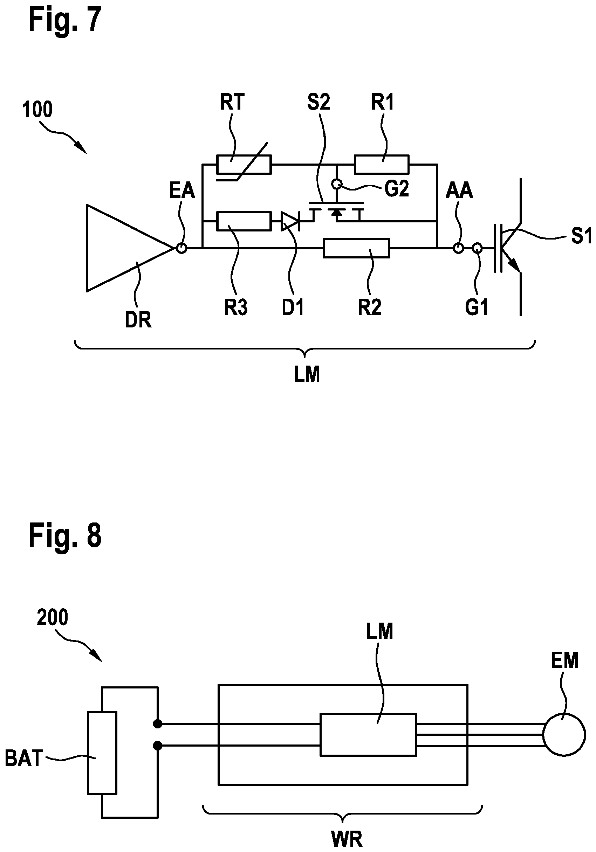

Gemäß Figur 7 ist ein Schaltungsmodul LM dargestellt, bestehend aus der Schaltungsanordnung 100 und dem Schaltelement S1. In einer alternativen Ausgestaltungsform umfasst das Schaltungsmodul LM auch die Treiberschaltung DR.

In Figur 8 ist ein elektrischer Antriebsstrang 200 dargestellt. Der elektrische Antriebsstrang 200 umfasst eine elektrische Maschine EM und einen Wechselrichter WR, der wiederum mindestens ein Schaltungsmodul LM, insbesondere mehrere geeignet angeordnete Schaltungsmodule LM, umfasst. Ein derartiger elektrischer Antriebsstrang 200 wird beispielsweise mittels einer Batterie BAT gespeist. Diese elektrische Energiequelle dient der Energieversorgung der elektrischen Maschine EM.

## Patentansprüche

1. Schaltungsanordnung (100) zur temperaturabhängigen Ansteuerung eines ersten Schaltelementes (S1) umfassend
einen Eingangsanschluss (EA) zur Entgegennahme eines Eingangspotentials, einen Ausgangsanschluss (AA) zur Weitergabe eines Ausgangspotentials an einen ersten Steueranschluss (G1) des ersten Schaltelementes (S1) und ein temperaturabhängiges Bauelement (RT), welches als temperaturabhängiger Widerstand ausgeführt ist,
weiter umfassend einen ersten Widerstand (R1)
wobei
das temperaturabhängige Bauelement (RT) zwischen den Eingangsanschluss (EA) und den Ausgangsanschluss (AA) geschaltet ist und wobei der erste Widerstand (R1) mit dem temperaturabhängigen Bauelement (RT) in Reihe zwischen den Eingangsanschluss (EA) und den Ausgangsanschluss (AA) geschaltet ist, **dadurch gekennzeichnet, dass** die Schaltungsanordnung (100) ein zweites Schaltelement (S2) umfasst, wobei das zweite Schaltelement (S2) zwischen den Eingangsanschluss (EA) und den Ausgangsanschluss (AA) geschaltet ist und der zweite Steueranschluss (G2) des zweiten Schaltelementes (S2) mit dem Mittelabgriff zwischen dem ersten Widerstand (R1) und dem temperaturabhängigen Bauelement (RT)verbunden ist.

2. Schaltungsanordnung (100) nach Anspruch 1,
weiter umfassend einen zweiten Widerstand (R2),
wobei der zweite Widerstand (R2) zwischen den Eingangsanschluss (EA) und den Ausgangsanschluss (AA) geschaltet ist.

3. Schaltungsanordnung (100) nach einem der vorherigen Ansprüche,
weiter umfassend einen dritten Widerstand (R3),
wobei der dritte Widerstand (R3) zwischen den Eingangsanschluss (EA) und den Source-Kontakt des zweite Schaltelement (S2) geschaltet ist.

4. Schaltungsanordnung (100) nach Anspruch 3,
weiter umfassend eine erste Diode (D1),
wobei die erste Diode (D1) zwischen den dritten Widerstand (R3) und den Source-Kontakt des zweiten Schaltelement (S2) geschaltet ist und einen Stromfluss von der Diode (D1) in Richtung des dritten Widerstandes (R3) verhindert.

5. Schaltungsanordnung (100) nach Anspruch 4,
weiter umfassend eine erste Diode (D1),
wobei die erste Diode (D1) zwischen den dritten Widerstand (R3) und den Source-Kontakt des zweiten Schaltelement (S2) geschaltet ist und einen Stromfluss von dem dritten Widerstand (R3) in Richtung des zweiten Schaltelementes (S2) verhindert.

6. Schaltungsmodul (LM) umfassend eine Schaltungsanordnung (100) zur temperaturabhängigen Ansteuerung eines ersten Schaltelementes (S1) nach einem der Ansprüche 1 bis 5 und das an den Ausgangsanschluss (AA) angeschlossene erste Schaltelement (S1)

7. Schaltungsmodul (LM) nach Anspruch 6 weiter umfassend eine an den Eingangsanschluss (EA) angeschlossene Treiberschaltung (DR)

8. Wechselrichter (WR) umfassend ein Schaltungsmodul nach den Ansprüchen 6 oder 7

9. Elektrischer Antriebsstrang umfassend einen Wechselrichter (WR) nach Anspruch 8 und eine elektrische Maschine (EM).

10. Verwendung einer Schaltungsanordnung (100) nach einem der Ansprüche 1 bis 5, insbesondere eines Schaltungsmodul nach einem der Ansprüche 6 und 7, insbesondere eines Wechselrichters nach Anspruch 8, insbesondere eines elektrischen Antriebsstrangs nach Anspruch 9, zur temperaturabhängigen Ansteuerung des ersten Schaltelementes (S1) in einem Kraftfahrzeug.

## Claims

1. Circuit arrangement (100) for the temperature-dependent actuation of a first switching element (S1) comprising
an input connection (EA) for receiving an input potential, an output connection (AA) for transferring an output potential to a first control connection (G1) of the first switching element (S1), and a temperature-dependent component (RT), which is embodied as a temperature-dependent resistor,
further comprising a first resistor (R1),
wherein
the temperature-dependent component (RT) is connected between the input connection (EA) and the output connection (AA)
and wherein the first resistor (R1) is connected in series with the temperature-dependent component (RT) between the input connection (EA) and the output connection (AA), **characterized in that** the circuit arrangement (100) comprises a second switching element (S2), wherein the second switching element (S2) is connected between the input connection (EA) and the output connection (AA) and the second control connection (G2) of the second switching element (S2) is connected to the centre tap between the first resistor (R1) and the temperature-dependent component (RT).

2. Circuit arrangement (100) according to Claim 1, further comprising a second resistor (R2),
wherein the second resistor (R2) is connected between the input connection (EA) and the output connection (AA).

3. Circuit arrangement (100) according to one of the preceding claims,
further comprising a third resistor (R3),
wherein the third resistor (R3) is connected between the input connection (EA) and the source contact of the second switching element (S2).

4. Circuit arrangement (100) according to Claim 3, further comprising a first diode (D1),
wherein the first diode (D1) is connected between the third resistor (R3) and the source contact of the second switching element (S2) and prevents a flow of current from the diode (D1) in the direction of the third resistor (R3) .

5. Circuit arrangement (100) according to Claim 4, further comprising a first diode (D1),
wherein the first diode (D1) is connected between the third resistor (R3) and the source contact of the second switching element (S2) and prevents a flow of current from the third resistor (R3) in the direction of the second switching element (S2).

6. Circuit module (LM) comprising a circuit arrangement (100) for the temperature-dependent actuation of a first switching element (S1) according to one of Claims 1 to 5 and the first switching element (S1) connected to the output connection (AA).

7. Circuit module (LM) according to Claim 6, further comprising a driver circuit (DR) connected to the input connection (EA).

8. Inverter (WR), comprising a circuit module according to Claims 6 or 7.

9. Electric drivetrain, comprising an inverter (WR) according to Claim 8 and an electric machine (EM).

10. Use of a circuit arrangement (100) according to one of Claims 1 to 5, in particular of a circuit module according to either of Claims 6 and 7, in particular of an inverter according to Claim 8, in particular of an electric drivetrain according to Claim 9, for the temperature-dependent actuation of the first switching element (S1) in a motor vehicle.

## Revendications

1. Circuit (100) destiné à la commande d'un premier élément de commutation (S1) en fonction de la température, ledit circuit comprenant
une borne d'entrée (EA) destinée à recevoir un potentiel d'entrée, une borne de sortie (AA) destinée à transmettre un potentiel de sortie à une première borne de commande (G1) du premier élément de commutation (S1) et un composant (RT), dépendant de la température, qui est conçu comme une résistance dépendant de la température,
ledit circuit comprenant en outre une première résistance (R1)
le composant (RT), dépendant de la température, étant monté entre la borne d'entrée (EA) et la borne de sortie (AA) et
la première résistance (R1) étant montée en série avec le composant (RT), dépendant de la température, entre la borne d'entrée (EA) et la borne de sortie (AA), **caractérisé en ce que** le circuit (100) comprend un deuxième élément de commutation (S2), le deuxième élément de commutation (S2) étant monté entre la borne d'entrée (EA) et la borne de sortie (AA) et la deuxième borne de commande (G2) du deuxième élément de commutation (S2) étant reliée à la prise centrale entre la première résistance (R1) et le composant (RT) dépendant de la température.

2. Circuit (100) selon la revendication 1, comprenant en outre une deuxième résistance (R2),
la deuxième résistance (R2) étant montée entre la borne d'entrée (EA) et la borne de sortie (AA).

3. Circuit (100) selon l'une des revendications précédentes, comprenant en outre une troisième résistance (R3),
la troisième résistance (R3) étant montée entre la borne d'entrée (EA) et le contact de source du deuxième élément de commutation (S2).

4. Circuit (100) selon la revendication 3, comprenant en outre une première diode (D1),
la première diode (D1) étant montée entre la troisième résistance (R3) et le contact de source du deuxième élément de commutation (S2) et empêchant un flux de courant de la diode (D1) en direction de la troisième résistance (R3).

5. Circuit (100) selon la revendication 4, comprenant en outre une première diode (D1),
la première diode (D1) étant montée entre la troisième résistance (R3) et le contact de source du deuxième élément de commutation (S2) et empêchant un flux de courant de la troisième résistance (R3) en direction du deuxième élément de commutation (S2).

6. Module de circuit (LM) comprenant un circuit (100) destiné à commander un premier élément de commutation (S1) en fonction de la température selon l'une des revendications 1 à 5 et le premier élément de commutation (S1) raccordé à la borne de sortie (AA).

7. Module de circuit (LM) selon la revendication 6 comprenant en outre un circuit d'excitation (DR) raccordé à la borne d'entrée (EA).

8. Onduleur (WR) comprenant un module de circuit selon les revendications 6 ou 7.

9. Chaîne cinématique électrique comprenant un onduleur (WR) selon la revendication 8 et une machine électrique (EM).

10. Utilisation d'un circuit (100) selon l'une des revendications 1 à 5, en particulier d'un module de circuit selon l'une des revendications 6 et 7, en particulier d'un onduleur selon la revendication 8, en particulier d'une chaîne cinématique électrique selon revendication 9, pour commander le premier élément de commutation (S1) en fonction de la température dans un véhicule automobile.
